# EUROPEAN PATENT SPECIFICATION

(11) **EP 1 451 834 B1**
(45) Date of publication and mention of the grant of the patent: **17.03.2010**
(21) Application number: 02760876.9
(22) Date of filing: 13.09.2002
(51) Int. Cl.: H01F 1/03

(54) **Method of preparing polymer composite using unidirectionally solidified giant magnetostrictive material**
Verfahren zur Herstellung eines Polymerverbundes durch Verwendung eines unidirektional erstarrten riesenmagnetostriktiven Materials
Procédé de préparation d'un composite polymèrique faisant appel à un matériau à magnétostriction géante solidifié unidirectionnellement

(30) Priority: 12.10.2001 KR 2001063086
(43) Date of publication of application: 01.09.2004
(73) Proprietor: Korea Advanced Institute of Science and Technology, Yuseong-gu, Daejeon-city 305-701 (KR)
(72) Inventor: PARK, Won Je, 503-233 Kwangju-city (KR); LEE, Zin Hyoung, 305-755 Daejeon-city (KR); HONG, Soon Hyung, 305-701, KOREA (KR); KWON, Oh Yeoul, 305-701, KOREA (KR)
(74) Representative: Plate, Jürgen
(86) International application number: PCT/KR2002/001724
(87) International publication number: WO 2003/032337

(56) References cited:
- EP-A1- 0 312 063
- US-A- 5 792 284
- PATENT ABSTRACTS OF JAPAN & JP 01 272 744 A (INOUE KIYOSHI) 31 October 1989

## Description

### TECHNICAL FIELD

The present invention pertains, in general, to methods of preparing a polymer composite using a giant magnetostrictive material, and more particularly, to a polymer composite having various improved properties, characterized in that the advantageous structure of the giant magnetostrictive material produced by unidirectional solidification can be maintained as it is by removing the rare earth phase or the eutectic phase from the magnetostrictive material and replacing the phase-removed void with a polymer resin.

### PRIOR ART

In general, the term magnetostriction means that a material has various lengths in response to change of a magnetic field and, as its reverse reaction, a magnetization state of the material is altered in response to external mechanical strain. Compared to PZT piezoceramic materials and nickel based magnetostrictive materials conventionally used as transducers or actuator devices, rare earth (hereinafter, abbreviated to "RE")-transition metal magnetostrictive materials are higher in magnetostrictive strain, with superior energy efficiency. Thus, the RE-transition metal magnetostrictive materials attain superiority over various application fields, and in particular, in the industrial fields related with aeronautics, communication, oil refining, automobiles, MEMS (micro electro mechanical system) and medicine. More specifically, such materials are used for high output actuators, linear and rotary motors, control of noise and vibration, pumps, fuel injection, robotics, position determination, valve actuations, micro positioning, sonar, audio systems, ultrasonic instruments, force sensing, endurance measurement, etc.

The RE-transition metal magnetostrictive material which is prepared by means of a unidirectional solidification is present in forms of a single crystal or aligned poly-grains. In order to obtain high magnetostrictive strain in such an alloy, grains in the alloy must be arranged in a specific direction. The reason is that upon unidirectional alignment of grains, the magnetostrictive strain is increased and internal loss generated at a grain boundary is also decreased. Such orientation in the magnetostrictive material is very important in the application fields to obtain high magnetostrictive strains at low magnetic field.

Among typical RE-transition metal magnetostrictive materials having aligned grains, there is highlighted an alloy comprising Tb_{0,3}Dy_{0.7}Fe_{1.9}. However, this alloy suffers from the disadvantages of short span life and difficult processing, due to high brittleness of a Laves phase (REFe₂ phase, in which RE means a complete solid solution of Tb and Dy). With the aim of solving these problems, a larger amount of terbium (Tb) and dysprosium (Dy) are added in order to form a larger amount of RE phase or the eutectic phase having superior ductility and toughness at boundaries of the Laves phase. As such, the RE phase or the eutectic phase comprises a densely formed network structure throughout the material.

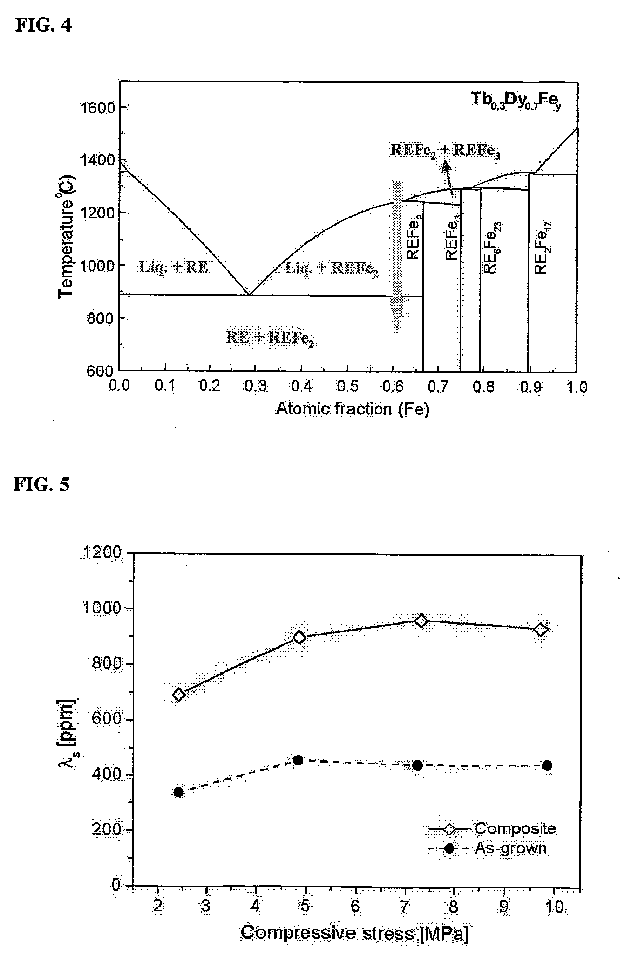

As the phase diagram Fig. 4 shows, the eutectic phase comprises RE phase and REFe₂ phase in a finely mixed state. When the total composition is very close to REFe₂ there is just a little amount of the eutectic phase formed, and in this case the REFe₂ phase of the eutectic structure which forms at the eutectic temperature, crystallizes at the nearby existing primary REFe₂ and only the RE phase is formed between large REFe₂ primary dendrites. This type of eutectic solidification is called divorced eutectic solidification. However, if the total composition is closer to the exact eutectic composition, a larger amount of eutectic phase is formed in a regular type of finely mixed state.

The major disadvantage of the unidirectionally solidified RE-transition metal magnetostrictive material is its low electric resistance, attributable to the metal. Thus, since heat generation and energy loss are large due to eddy currents upon use of such a material in the ranges of high frequencies, the use of the above material is limited in the application fields requiring high frequency ranges. Hence, there is used the method of reducing the eddy current loss by cutting the material to thin sheets (1 mm thickness) and layering them with insulator inbetween. But such layering process is difficult and expensive to perform because the RE-transition metal magnetostrictive material is hard and very fragile.

As an alternative, powders of the RE-transition metal magnetostrictive material are mixed with the polymer resin and prepared as a polymer composite, which is advantageous in terms of simple preparation process, low cost and easy compaction to various shapes. However, since small grains having magnetostrictive property are dispersed in a non-magnetic polymer matrix, the above composite is disadvantageous in light of inferior crystal orientation and low magnetization strength and thus much lower magnetostrictive strain, compared to the unidirectionally solidified material. Even so, more important advantages of the composite material are its good mechanical toughness and high electric resistance, due to the polymer matrix functioning as the insulator. By increasing the electric resistance, heat generation by eddy current is decreased and the usable frequency range is increased from several tens of kHz to several hundreds of kHz. In the case of preparing the composite by use of TbₓDy₁₋ₓFe_{2-w}, the total energy loss by eddy current is decreased to 1/6 level compared to unidirectionally solidified bodies. In addition, the composite has higher toughness under tensile stress.

Conventionally, the polymer composite is prepared as follows.
(1) the cast RE-Fe magnetostrictive material ingot is pulverized under inert gas atmosphere to make grains;
(2) the particles are mixed with a polymer binder and pores present therein are removed;
(3) a mixture of the resin and the grains is compacted under pressure, provided that an external magnetic field of 100 Oe or more is vertically applied relative to a pressure axis to the grains for unidirectional alignment thereof upon compacting; and
(4) the polymer resin is cured to produce the composite having excellent mechanical properties.

At present, the polymer composite is considerably lower in magnetostrictive strain than the unidirectionally solidified bodies, since the grains of the magnetostrictive material are very small and have poor crystal orientation. The reason why fine grains are low in magnetostrictive strain is that saturation magnetization strength of the surface is lower than that in the bulk, and as the distance between grains becomes longer, a coupling force therebetween is decreased. In particular, as in RE-iron magnetostrictive material, it is very important that the texture is maintained in the favorable crystal orientation, having a large magnetostriction.

Meanwhile, the RE-transition metal magnetostrictive material can be further increased in its magnetic properties through annealing. As for the RE-iron magnetostrictive material, the annealing process is performed at a temperature higher than 887 °C, the eutectic temperature (see Fig. 4). In some cases, a magnetic field or compressive stress may be applied during annealing. However, such annealing process may cause the following problems, in which the RE phase or eutectic phase is melted at a temperature higher than the eutectic temperature and flows out of the material. In the RE phase-removed structure, the magnetic properties are improved but toughness of the material become much worse because the RE phase-removed portion forms a void, and the material is easily fractured. To prevent such phenomenon, the annealing process should be performed at a temperature lower than the eutectic temperature or the fraction of the RE phase should be decreased. However, the former case is disadvantageous because of a smaller heat treatment effect, and the latter case suffers from the drawback of low toughness.

### DISCLOSURE OF THE INVENTION

Therefore, it is an object of the present invention to alleviate the problems in the prior art and to provide a method of preparing an aligned polymer composite, exhibiting excellent properties in high frequency ranges due to increased electric resistance and having high fracture resistance due to improved toughness of the material as well as improved magnetic properties, while a unidirectionally aligned texture of a unidirectionally solidified magnetostrictive material is maintained as it is.

### BRIEF DESCRIPTION OF THE DRAWINGS

Fig. 1a is a view showing a schematic structure of a unidirectionally solidified giant magnetostrictive material, as a unidirectionally aligned composite comprising Laves (or REFe₂ phase) and RE phase or eutectic phase;
Fig. 1b is a view showing a void-formed structure after removal of a RE or eutectic phase from the structure shown in Fig. 1a through annealing;
Fig. 1c is a view showing a structure of the composite after infiltration of a polymer resin;
Fig. 2a is an scanning electron microscopic photograph showing a RE phase-removed material having only a REFe₂ phase;
Fig. 2b is a photograph showing a structure of a cross-section of a polymer infiltrated composite, observed by an electron microscope;
Fig. 3a is a photograph showing a structure of a unidirectionally solidified terfenol-D containing 80 vol% of a REFe₂ phase, observed by an optical microscope;
Fig. 3b is a photograph showing a structure of a polymer composite made of the material shown in Fig. 3a, observed by an optical microscope;
Fig. 4 is a pseudobinary phase diagram of (Tb_{0.3}Dy_{0.7})-Fe;
Fig. 5 is a graph comparing saturation magnetostriction of a conventional magnetostrictive material and a polymer composite by the present invention under various compressive stresses; and
Fig. 6 compares the magnetostriction (λ) versus magnetic field (H) curves under a compressive stress of 7 MPa for the two materials of above Fig. 5.

### BEST MODES FOR CARRYING OUT THE INVENTION

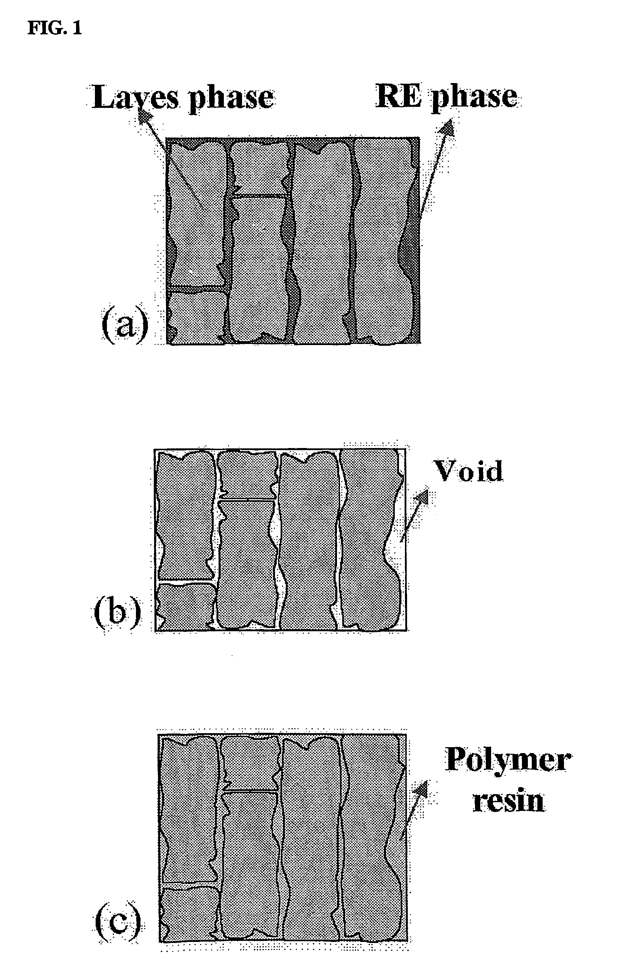

The present invention provides a method of preparing a polymer composite using a giant magnetostrictive material with a RE phase, comprising the steps of removing the RE phase from a unidirectionally solidified giant magnetostrictive material shown in Fig. 1a and Fig. 1b; and infiltrating a polymer resin to a RE phase-removed void, followed by curing the infiltrated resin (Fig. 1c).

The polymer composite of the present invention is excellent in magnetostriction because a Laves phase comprising a texture formed by unidirectional solidification is maintained as it is, compared to conventional polymer composites containing the Laves phase of a powder form,.

In the giant magnetostrictive material usable in the present invention, a phase showing a giant magnetostriction phenomenon is contained, together with the RE phase. As the phase showing magnetostriction, use is preferably made of a rare earth-iron magnetostrictive material having grains aligned by unidirectional solidification, with excellent properties. Further, the iron element constituting the Laves phase may be alloyed with small amounts of other metals, for example, aluminum, manganese, cobalt and so on. In this regard, the rare earth-iron magnetostrictive material is exemplified by TbₓDy₁₋ₓFc_{2-w} (0.20≤x≤1.00, 0≤w≤0.20), TbₓHo₁₋ₓFe_{2-w}(0.10≤x≤1.00, 0≤w≤0.20), SmₓDy₁₋ₓFe_{2-w}(0.80≤x≤1.00, 0≤w≤0.20), SmₓHo₁₋ₓFe_{2-w} (0.60≤x≤1.00, 0≤w≤0.20), TbₓHo_{y}Dy_{z}Fe_{2-w} (0.10≤x≤1.00, 0≤y≤0.9, 0≤z≤0.8, 0≤w≤0.20, x+y+z=1), SmₓHo_{y}Dy_{z}Fe_{2-w} (0.60≤x≤1.00, 0≤y≤0.4, 0≤z≤0.4, 0≤w≤0.20, x+y+z=1), etc. Of them, TbₓDy₁₋ₓFe_{2-w} (0.27≤x≤0.35) is preferably used in light of excellent magnetostrictive characteristics. More preferably, Tb_{0.3}Dy_{0.7}Fe_{1.9}(alias, known to "terfenol-D") is used.

The giant magnetostrictive material having grains aligned by unidirectional solidification may be obtained by known methods (eg, Bridgman method, float zone melting, Czochralski method, etc.), which are apparent to those skilled in the art.

The RE phase or the eutectic phase is distributed between the primary REFe₂ phases forming a network structure, the amount of which can be controlled by controlling the total composition of a giant magnetostrictive material. Removal of the RE phase can be achieved by thermally annealing the giant magnetostrictive material at a temperature higher than the eutectic temperature. Such annealing process functions to melt the eutectic structure containing the RE phase and causing it to flow out. At the same time, magnetic properties of the Laves phase are further increased by this annealing. The molten eutectic structure flows out of the material due to a high interfacial energy with the Laves phase. Since the Laves phase may coarsen during heat treatment but the unidirectionally aligned dendrite structure can be maintained as it is, the annealing process is very advantageous. The RE elements constituting the giant magnetostrictive material generally have a high tendency to oxidize, and thus the annealing process is preferably performed under inert gas or vacuum atmosphere.

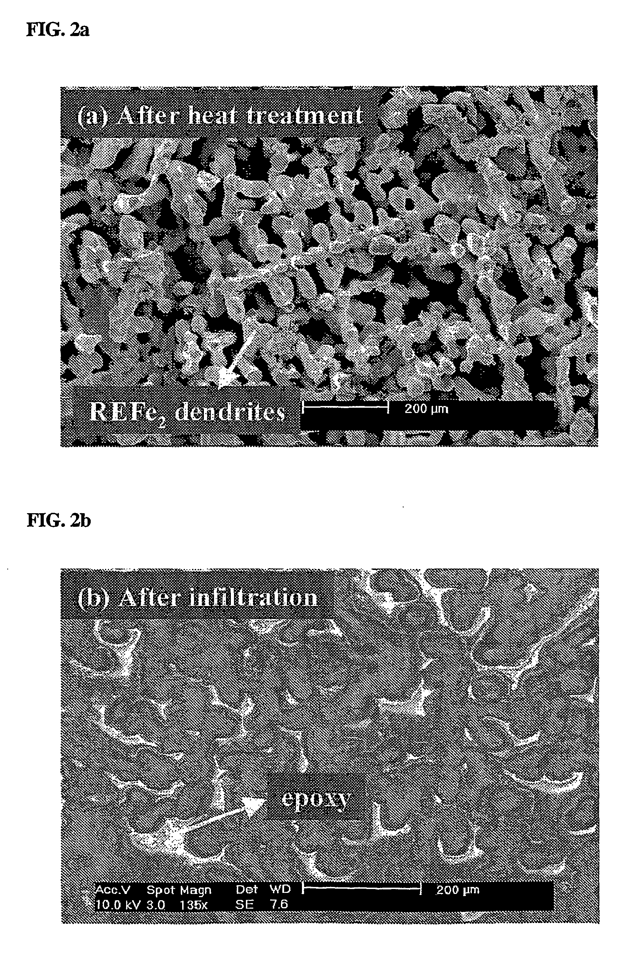

In Fig. 2a, it can be seen that the giant magnetostrictive material represented by TbₓDy₁₋ₓFe_{2-w} is annealed to remove the RE phase, whereby only REFe₂ dendrite phase showing magnetic properties remains in the material structure. After the polymer resin is infiltrated to the material structure, the surface is polished. The polished structure is shown in Fig. 2b. From this drawing, it can be seen that REFe₂ phase is maintained as the aligned dendrite structure obtained from casting, while the RE or eutectic phase portion is replaced with the polymer resin.

The process of replacing the polymer resin to the RE phase-removed void in the structure of the magnetostrictive material is carried out by means of known methods, for example, infiltration. The polymer resin introduced into the material structure via infiltration is formed in a densely connected network structure in the material, thereby preventing propagation of cracks or absorbing fracture energy, thus providing high fracture resistance. In order that the polymer resin is completely filled into fine channels in the material, all gases present in the material should be removed under vacuum before the infiltration process is performed.

As the polymer resin applied to the infiltration process is preferably used a non-conductor to increase electric resistance. More preferably, with the aim of obtaining excellent wetting property between the polymer and the metal matrix and complete infiltration through fine channels, a polymer resin having low viscosity is used. The polymer resin may be suitably selected according to the properties required by those skilled in this art and is not specifically limited. Therefore, in the present invention, various polymer resins having different properties are applied and the giant magnetostrictive material combining various properties of polymers can be realized.

The polymer resin meeting the above requirements includes thermosetting resins or thermoplastic resins, which are exemplified by epoxy resin, phenol resin, polyimide, polystyrene, etc. These resins are lower in Young's modulus than the rare earth metal phase. So, the replacement of the RE phase with polymer resin leads to further increased magnetostrictive strain because the elongation of REFe₂ phase is constrained less by polymers than by RE.

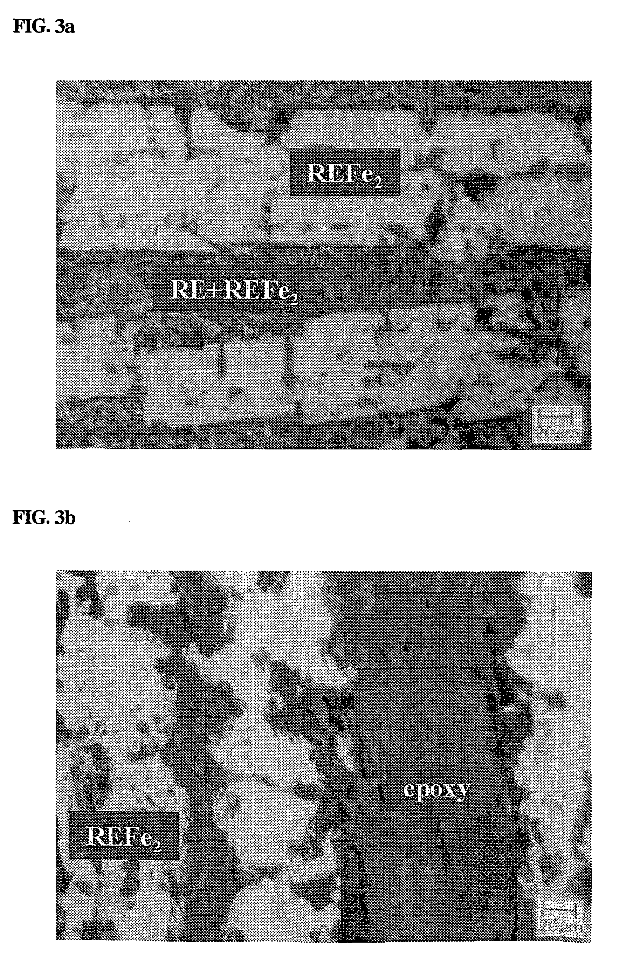

Fig. 3a shows a structure of a cross-section of a unidirectionally solidified material, comprising 60 vol% of primary REFe₂ phase and 40 vol% of eutectic phase. Fig. 3b shows a structure of a cross-section of the polymer composite obtained by annealing the material shown in Fig. 3a at 1000 °C for 6 hours to remove the eutectic phase, and infiltrating the epoxy resin heated to 80 °C into the eutectic phase-removed voids, followed by curing the infiltrated resin.

Finally, the curing process of the infiltrated resin may be carried out via general methods. For example, in case of YD-114 epoxy resin, the resin is maintained at 80 °C for 2 hours and cured. As such, a predetermined pressure may be applied to the composite material in order to collapse pores present in the composite and to prevent formation of bubbles in the resin. The curing of resin is an exothermic reaction and thus thermal stress resides in the cured polymer composite due to different thermal expansion coefficients between the Laves phase and the polymer resin. The Laves phase having a lower thermal expansion coefficient is subjected to compressive residual stress. The magnetostrictive strain of the polymer composite is increased proportionally to the compressive stress parallel to the measuring direction. Thus, the residual thermal stress generated by the above procedure consequently functions to improve the magnetostrictive strain of the composite.

A better understanding of the present invention may be obtained in light of the following examples which are set forth to illustrate, but are not to be construed to limit the present invention.

### EXAMPLE 1

Preparation of Polymer Composite using Tb_{0.3}Dy₀.₇Fe_{1.32}

In the present example, as a giant magnetostrictive material, an alloy comprising 90 vol% of primary REFe₂ phase and 10 vol% of eutectic phase was used. In Fig. 4 showing a pseudobinary phase diagram of the alloy, terbium (Tb) and dysprosium (Dy) form a complete solid solution. The "RE" in the drawing means a rare earth phase of TbₓDy₁₋ₓ, and REFe₂ is defined as a Laves phase having giant magnetostrictive property.

To prevent the alloy rod from being oxidized at a high temperature, the alloy rod was charged into a quartz tube, which was then filled with highly pure argon gas, and the tube was sealed, followed by performing annealing process at 1000 °C for 6 hours to remove the eutectic phase. A sample having fine open pores was infiltrated with YD-114 epoxy resin as follows. Into a chamber (autoclave) capable of being subjected to evacuation and pressurization, the epoxy resin heated up to 80 °C and the sample were separately charged, and the chamber was evacuated to remove air present in the pores of the sample, followed by dipping the sample into liquid phase epoxy resin and curing it for 2 hours (as such, the pressure of about 5 atm was applied to more easily perform infiltration).

Fig. 5 compares the saturation magnetostrictive strains of the magnetostrictive material having the above composition and the composite produced by the example of the present invention. In the graph, a dotted line shows the saturation magnetostrictive strain of the magnetostrictive material solidified unidirectionally, and a full line shows the saturation magnetostrictive strain of the polymer composite having two times higher magnetostrictive strain than the material represented by the dotted line. In Fig. 5, a transverse axis shows 10 the compressive pre-stress during the measurement of the magnetostrictive strain, in which the magnetostrictive strain of the rare earth-based magnetostrictive material as in the alloy having the above composition varies with the pre-stress.

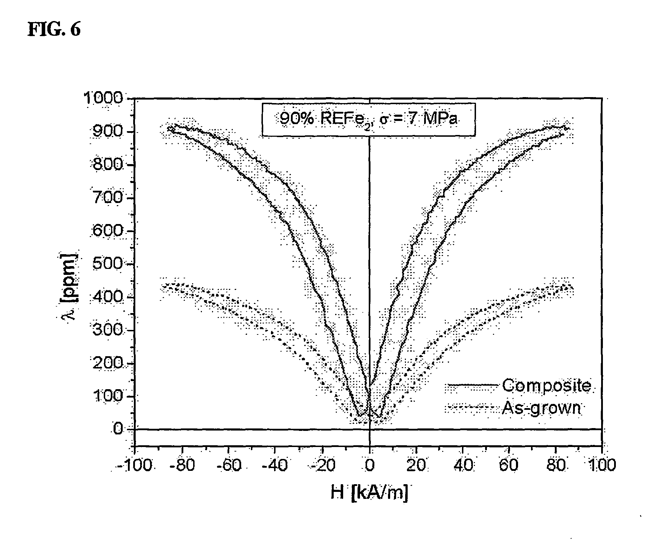

Fig. 6 compares magnetostriction curves measured in the state where a compressive stress of 7 Mpa is applied to the material. From this figure, it can be seen that the magnetostrictive strain varies with the strength of the applied magnetic field. In the drawing, the dotted line corresponds to unidirectionally solidified alloy and the full line to the composite material.

Meanwhile, the electric resistances of the unidirectionally solidified alloy and the polymer composite are given in Table 1, below, in which the larger the amount of the epoxy resin substituted for the eutectic phase, the higher the resistivity.

**TABLE 1 Measured Electric Resistance**

| No. | State | REFe₂ Phase (vol%) | Number of measurements | Average Resistivity (µΩm) |
|---|---|---|---|---|
| 1 | Metal | 95 | 5 | 8.0 |
| 2 | Composite | 90 | 10 | 900 |
| 3 | Composite | 60 | 10 | 2500 |
| 4 | Composite | 40 | 12 | 20000 |

### INDUSTRIAL APPLICABILITY

According to the present invention, the electric resistance of the magnetostrictive material is increased due to the polymer resin serving as an insulator, and thus eddy current loss can be decreased and toughness of the material can be improved, attributable to the polymer resin network formed in the material structure. Further, by using the polymer resin having lower Young's modulus than the rare earth metals, the magnetostrictive strain of the inventive polymer composite is higher than that of the magnetostrictive material containing the eutectic phase of the same volume fraction as the polymer resin. Furthermore, the preparation method involving the annealing process can increase magnetic properties.

The present invention has been described in an illustrative manner, and it is to be understood that the terminology used is intended to be in the nature of description rather than of limitation. Many modifications and variations of the present invention are possible in light of the above teachings. Therefore, it is to be understood that within the scope of the appended claims, the invention may be practiced otherwise than as specifically described.

## Claims

1. A method of preparing an aligned polymer composite by use of a giant magnetostrictive material having grains of Laves phase (REFe₂ phase) aligned by unidirectional solidification and; a eutectic phase (rare earth phase) distributed between the primary REFe₂ phase, **characterized by** comprising the following steps:
removing the eutectic phase, containing the rare earth phase from the unidirectionaly solidified giant magnetostrictive material and;
infiltrating a polymer resin to the rare earth phase-removed void, followed by curing the infiltrated resin.

2. The method as set forth in claim 1, wherein the removing step of a eutectic structure containing the rare earth phase is performed by thermally annealing the magnetostrictive material at a temperature higher than the eutectic temperature.

3. The method as set forth in claim 1, further comprising the step of removing all gases present in the magnetostrictive material under vacuum before the infiltrating step.

4. The method as set forth in claim1, further comprising the step of applying pressure to prevent formation of pores in the resin upon curing.

5. The method as set forth in claim 1, wherein the giant magnetostrictive material comprises a rare earth-iron magnetostrictive alloy.

6. The method as set forth in claim 5, wherein the rare earth-iron magnetostrictive alloy is selected from the group consisting of :
TbₓDy₁₋ₓFe_{2-w} (0.27< x<0. 35, 0 < w < 0. 20); TbₓHo₁₋ₓFe_{2-w} (0.10<x< 1.00, 0<w< 0.20); SmₓDy₁₋ₓFe_{2-w} (0.80<x<1.00, 0<w<0.20); SmₓHo₁₋ₓFe_{2-w} (0.60<x<1.00, 0<w<0.20); TbₓHo_{y}Dy_{z}Fe_{2-w} (0.10<x<1.00, 0<y<0.9, 0<z<0.8, 0<w<0.20, x+y+z=1) ; and SmₓHo_{y}Dy_{z}Fe_{2-w} (0.60<x<1.00, 0<y<0.4, 0<z<0.4, 0<w<0.20, x+y+z=1).

## Patentansprüche

1. Ein Verfahren zum Herstellen eines Polymerverbundwerkstoffs durch die Verwendung eines riesenmagnetostriktiven Materials, welches durch unidirektionale Verfestigung ausgerichtete Laves-Phase-Körner (REFe₂-Phase) aufweist; und eine eutektische Phase (Seltenerdphase), zwischen der primären REFe₂-Phase verteilt, **gekennzeichnet durch** das Umfassen der folgenden Schritte:
Entfernen der eutektischen Phase, welche die Seltenerdphase aus dem unidirektional verfestigten riesenmagnetostriktiven Material enthält und;
Tränken des Hohlraums ohne Seltenerdphase mit einem Polymerharz gefolgt vom Härten des infiltrierten Harzes.

2. Verfahren nach Anspruch 1, wobei der Schritt des Entfernens einer die Seltenerdphase enthaltenden eutektischen Struktur durch thermisches Glühen des magnetostriktiven Materials bei einer Temperatur über der eutektischen Temperatur durchgeführt wird.

3. Verfahren nach Anspruch 1, weiterhin mit dem Schritt des Entfernens aller in dem magnetostriktiven Material vorliegenden Gase in Vakuum vor dem Infiltrierungsschritt.

4. Verfahren nach Anspruch 1, weiterhin mit dem Schritt des Ausübens von Druck, um die Entstehung von Poren in dem Harz beim Härten zu verhindern.

5. Verfahren nach Anspruch 1, wobei das riesenmagnetostriktive Material eine magnetostriktive Seltenerd-Eisen-Legierung umfasst.

6. Verfahren nach Anspruch 5, wobei die magnetostriktive Seltenerd-Eisen-Legierung ausgewählt ist aus der Gruppe bestehend aus: TbₓDy₁₋ₓFe_{2-w} (0,27<x<0,35, 0<w<0,20); TbₓHo₁₋ₓFe_{2-w} (0,10<x<1,00, 0 <w< 0,20); SmₓDy₁₋ₓFe_{2-w} (0,80 <x<1,00, 0<w<0,20); SmₓHo₁₋ₓFe_{2-w} (0,60<x<1,00, 0<w<0,20); TbₓHo_{y}Dy_{z}Fe_{2-w} (0,10<x<1,00, 0<y<0,9, 0<z<0,8, 0<w<0,20, x+y+z=1); und SmₓHo_{y}Dy_{z}Fe_{2-w} (0,60<x<1,00, 0<y<0,4, 0<z<0,4, 0<w<0,20, x+y+z=1).

## Revendications

1. Procédé de préparation d'un composite polymère aligné en utilisant un matériau magnétostrictif géant présentant des grains de phase de Laves (phase REFe₂) alignés par solidification unidirectionnelle et ; une phase eutectique (phase de terres rares) distribuée entre la phase primaire REFe₂, **caractérisée en ce qu'**elle comprend les étapes consistant à :
éliminer la phase eutectique, contenant la phase de terres rares, du matériau magnétostrictif géant solidifié de manière unidirectionnelle et ;
infiltrer une résine polymère dans le vide obtenu par élimination de la phase de terres rares, puis durcir la résine infiltrée.

2. Procédé selon la revendication 1, dans lequel l'étape d'élimination d'une structure eutectique contenant la phase de terres rares est effectuée par recuit thermique du matériau magnétostrictif à une température supérieure à la température eutectique.

3. Procédé selon la revendication 1, comprenant en outre l'étape consistant à éliminer sous vide tous les gaz présents dans le matériau magnétostrictif avant l'étape d'infiltration.

4. Procédé selon la revendication 1, comprenant en outre l'étape d'application d'une pression dans le but d'éviter la formation de pores dans la résine lors du durcissement.

5. Procédé selon la revendication 1, dans lequel le matériau magnétostrictif géant comprend un alliage magnétostrictif de type terres rares-fer.

6. Procédé selon la revendication 5, dans lequel l'alliage magnétostrictif de type terres rares-fer est choisi dans le groupe comprenant les combinaisons suivantes : TbₓDy₁₋ₓFe_{2-w} (0,27 < x < 0, 35, 0 < w < 0, 20) ; TbₓHo₁₋ₓFe_{2-w} (0,10 < x < 1,00, 0 < w < 0, 20) ; SmₓDy₁₋ₓFe_{2-w} (0,80 < x < 1,00, 0 < w < 0, 20) ; SmₓHo₁₋ₓFe_{2-w} (0,60 < x < 1,00, 0 < w < 0, 20) ; TbₓHo_{y}Dy_{z}Fe_{2-w} (0,10 < x < 1,00, 0 < y < 0,9, 0 < z < 0,8, 0 < w < 0,20, x + y + z = 1) ; et SmₓHo_{y}Dy_{z}Fe_{2-w} (0,60 < x < 1,00, 0 < y < 0,4, 0 < z < 0,4, 0 < w < 0,20, x + y + z = 1).
